Europäisches Patentamt

European Patent Office

Office européen des brevets

(11) Publication number: **0 314 185**
**A1**

## EUROPEAN PATENT APPLICATION

(21) Application number: **88118138.2**

(22) Date of filing: **31.10.88**

(51) Int. Cl.⁴: **G03F 7/26**

(30) Priority: **29.10.87 JP 273695/87**
**11.11.87 JP 284508/87**
**08.01.88 JP 2870/88**
**08.01.88 JP 2871/88**
**08.01.88 JP 2872/88**
**29.06.88 JP 161652/88**

(43) Date of publication of application:
**03.05.89 Bulletin 89/18**

(84) Designated Contracting States:
**DE FR GB**

(71) Applicant: **Matsushita Electric Industrial Co.,**
**Ltd.**
**1006, Oaza Kadoma**
**Kadoma-shi Osaka-fu, 571(JP)**

(72) Inventor: **Endo, Masayuki**
**782, Kurodoricho**
**Izumi-shi(JP)**
Inventor: **Sasago, Masaru**
**1-3-14, Kohoku-1-chome**
**Hirakata-shi(JP)**
Inventor: **Ueno, Atushi**
**52-9, Nagao Motomachi-7-chome**
**Hirakata-shi(JP)**
Inventor: **Nomura, Noboru**
**35, Fukakusa Nakanoshimacho Fushimi-ku**
**Kyoto(JP)**
Inventor: **Matsuoka, Koji**
**Shoeiryo 30-23, Miyukihigashimachi**
**Neyagawa-shi(JP)**

(74) Representative: **Patentanwälte Leinweber &**
**Zimmermann**
**Rosental 7/II Aufg.**
**D-8000 München 2(DE)**

(54) **Pattern forming method.**

(57) The present invention provides a method of forming through exposure and development by performing an aqueous solution treatment after forming a resist. This method increases a difference in the rate of dissolving in a developer between exposed and unexposed portions on the resist. As a result, a fine, good and well-shaped pattern with an improved contrast may be obtained very simply.

The method according to the present invention is very well suited to a means for improving the contrast of a resist which includes the use of an optically fading compound layer, a far ultraviolet ray radiation, or the like, whereby the present inventive method works more effectively. Besides, a surface active agent may be contained in said water solution. Heating may be performed after completion of said water solution treatment. These materials and treatments can improve the contrast of a resist by increasing a difference in rate of dissolving in a developer between unexposed and exposed portion on said resist.

## PATTERN FORMING METHOD

BACKGROUND OF THE INVENTION:

This invention relates to a method of forming patterns in a lithographic process for producing semiconductors, etc.

In the lithographic process of semiconductor production, it is most important to form a fine and well shaped resist pattern.

In the lithography generally applied at present by the use of ultraviolet rays [g-line (436 nm) ray, i-line (365 nm) ray, etc.], excimer laser rays [ArF (193 nm), KrF (249 nm) ray, XeCl (308 nm) ray, etc.], it is often difficult to obtain a fine (e.g. around 0.5 μm thru 1.0 μm) pattern of good shape, judging from the optical pattern resolution capability of lithography.

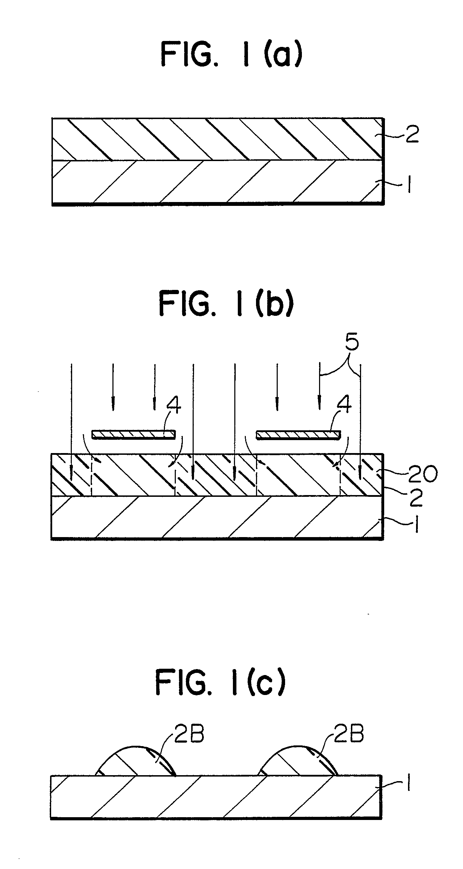

Fig. 1 is used to show a method of forming patterns through the conventional technology referred to above. On printed Circuit Board 1, Positive Resist 2 (MPS-14000: Shipley) is so formed as to be 1.2 μm thick (Fig. 1a). Subsequently the resist is selectively exposed to g-line (436 nm) rays 5 through Mask 4. The exposure unit then employed is a contracted projection exposer (NA 0.42; Nippon Kogaku) set to an exposure of 220 mJ/cm² (Fig. 1b). Finally, an alkaline developer (MF319; Shipley) is applied to perform a 60 seconds' puddle development so that Resist Pattern 2B is formed, with Resist Exposed Portion 20 removed (Fig. 1c).

Pattern 2B, however, though it is a 0.6 μm line-and space pattern, is defective as characterized by an approximately 15% loss of film and by a semicircular improperly shaped form. The reason why such defect has arisen is apparently because the mask pattern has dimensions of a pattern near the limits of the optical system. As a result, those portions located just below the mask, which are to be originally unexposed, have received a diffraction of the rays, to which they have been eventually exposed. Thus, the portions have been developed and removed. Such defective pattern will cause dimensional variations in such subsequent processes as etching, ion injection, etc., leading to a decrease in yield in producing semiconductor devices. The problem is therefore quite large.

In the lithography with electron or ultraviolet rays applied, moreover, some attempts have been made to form a pattern in a favorable shape. In other words, an electron resist or ultraviolet resist is treated with an organic solvent (chlorobenzene) first. After that, the resist is subjected to electron irradiation or exposure to ultraviolet rays and developed. (e.g., Mitani et al., Proceedings of the 1988 Spring Session of Applied Physics Society's Lecture Meeting, p. 414, 21a-N-4 (1987) This process, however, has a high possibility that chlorobenzene, an organic medium, mixes and/or reacts with the resist, resulting in the deterioration of the latter or in a deformation of the pattern upon its formation. Besides, it is difficult to control the chlorobenzene treatment time. Too short a treatment time will bring ineffective results. Too long a chlorobenzene treatment time would make the resist completely insoluble at the portions exposed, thereby said portions become resistant to development treatment. As a result, such a phenomenon as failure of development and the like occurs thereafter. The treatment temperature, moreover, is also difficult to control. Thus, it is inapplicable to the lithography process owing to the control difficulties. Besides the unavoidable use of an organic solvent has problems from the viewpoints of industrial production, in addition to the problems of safety and health of workers.

As one of lithography technologies, moreover, the contrast enhanced lithography (CEL) has been proposed, for example, by B. F. Griffing et al., IEEE Electron Device Letter EDL-P.4 (1982). This technology is such that a well shaped resist pattern with a contrast improved can be obtained because a faded dye layer formed on the resist transfers thereinto only those light components which have a higher light intensity of the incident that is, contrast improved.

With such CEL technology applied, however, in case of a submicron or smaller class pattern, especially an approximately 0.6 μm pattern, the incident light contrast is not improved so conspicuously, and thus neither is the pattern so well-shaped.

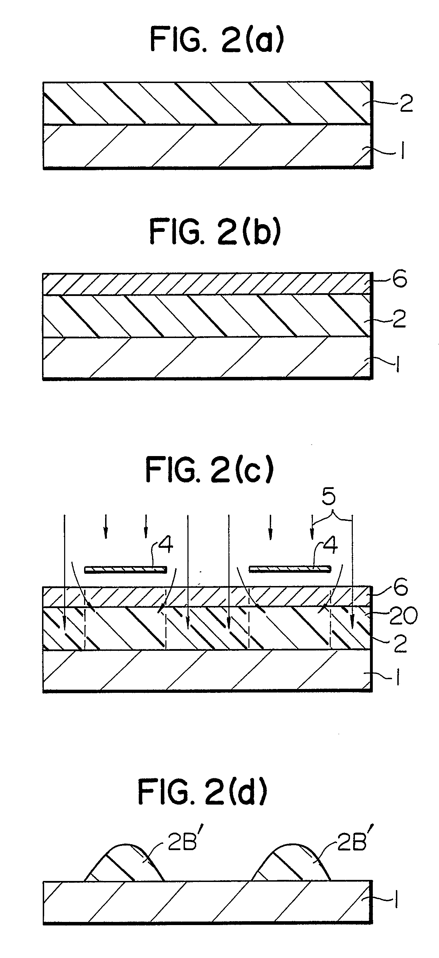

With referring to Fig. 2, an explanation will be given concerning a conventional pattern forming method, in which a water soluble CEL material is applied (e.g. M. Sasago et al., Proc. SPIE. 631, P. 321 (1986)).

On substrate 1, Positive Resist 2 (MPS 1400: Shipley) is formed to a thickness of 1.2 μm (Fig. 2a). Subsequently, Water-soluble CEL Material 6 having a composition specified below is coated to a thickness of 0.15 μm.

| 4,4'-dimethylaminophthalane diazonium chloride zinc salt | 2.0 grams |
| Polystyrene sulphonic acid (molecular weight 40,000) | 8.0 grams |
| Distilled water | 48.0 grams |

This Material Layer 6 showed Contrast Effect Coefficient A of 12 which is given by dividing logarithmic values of the transmittance ratios before and after exposure at 436 nm by the film thickness (Fig. 2b).

Subsequently, the resist selectively exposed to g-line (436 nm) rays 5 through Mask 4. In this case, a contrasted projection exposer (NA 0.42: Nippon Kogaku) was used for the exposure at an exposed light quantity of 240 mJ/cm² (Fig. 2c).

Finally, an alkaline developer (MF319 Shipley) was used to perform a 60 seconds' puddle development so that Resist Pattern 2B' was formed by removing both Water Soluble CEL Layer 6 and Exposed Portion 20 of Resist 2 (Fig. 2d). Thus formed Pattern 2B' was a 0.5 $\mu$m line-and- space pattern. Nevertheless, the light diffraction phenomenon caused the rays to scatter into and develop those portions which were to be originally unexposed. As a result, an approximately 10% film loss occured and the pattern was so unstable as to have an aspect ratio of 65°. Such an improperly shaped defective pattern as shown in Fig. 2d will cause dimensions to vary in such subsequent processes as etching, ion injection, etc. It leads to a decrease in yield in producing semiconductor devices and has been deemed a problem to be overcome.

The same results as referred to above were also obtained when used a commercially available nonwater-soluble CEM420 (mfd by Nagase Sangyo, A = 12) as a CEL material substitute.

SUMMARY OF THE INVENTION:

The present invention is aimed at dissolving the pattern forming deterioration problem in a conventional pattern forming method by the use of an easy and industrially favorable process.

The present invention further is aimed at forming fine and well shaped resist patterns by simply treating the resist on the surface after forming a rcsist film.

Moreover, the present invention is aimed at forming a fine, well-shaped resist pattern by using a contrast enhanced material, or a contrast enhanced method such as whole exposure under ess humidic conditions mentioned later.

The present invention provides a pattern forming method which comprises treating a resist after forming with an aqueous solution, exposure and development so as to form a resist pattern.

According to the method of the present invention a well-shaped and fine resist pattern can be easily obtained by increasing the difference in dissolving rates of unexposed and exposed portions on a resist in a developing solution.

BRIEF DESCRIPTION OF THE DRAWINGS:

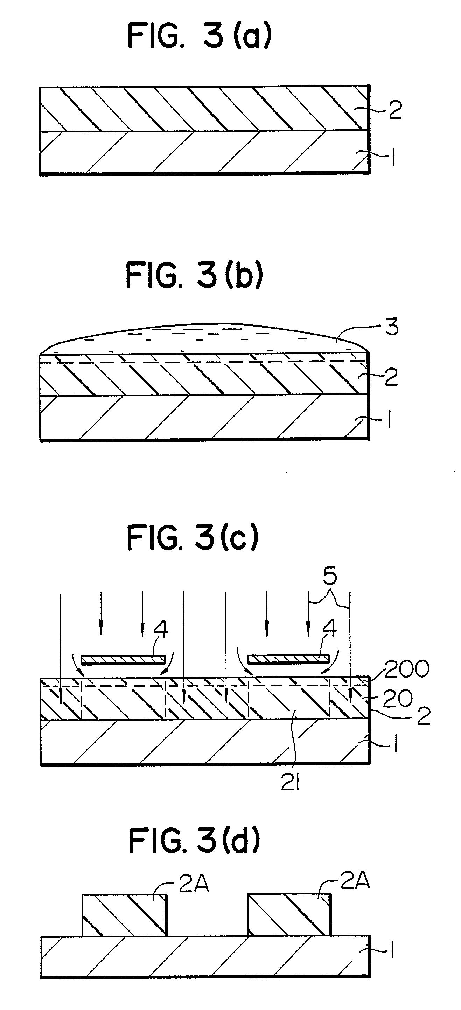

Figs. 1 and 2 are cross sectional views showing steps for forming patterns in the prior art Figs. 3 to 9 cross sectional views showing steps for forming patterns according to the present invention.

DETAILED DESCRIPTION OF THE INVENTION:

The inventors have found that an aqueous solution treatment according to the present invention makes the upper part of a resist difficult to dissolve in an alkaline developer so that an excellent resist pattern can be formed. This phenomenon has led to an increased difference in developing rate between exposed and unexposed portions upon exposure and development. In other words, the aqueous solution treatment according to the present invention has scarcely changed the developing rate of the exposed-portion from those not so treated. On the contrary, even if the unexposed portion to be originally light-shielded is exposed to a weak diffracted light due to incident into the resist through mask, such portion will be resistant to dissolve in a developing solution because as mentioned above, due to the formation of upper layer resistant to alkaline developing solution, and unintentional exposed portion hardly dissolves in alkaline developing solution. Therefore, there is no occurrence of such a phenomenon that, a portion to be originally neither developed nor removed is developed. Accordingly, the light diffraction turns out completely negiligible while the developing speed is improved to a great extent, and a well-shaped resist pattern is formed.

Such an increase in difference of developing speed between exposed and unexposed portions obviously turns out an increase in contrast of the resist pattern. The reason why the aforesaid resist becomes resistant to dissolution in an alkaline developing solution in the upper part is considered that the resist turns hydrophobic or nonsensitive due to the treatment with aqueous solution. In other words, it may be reasonably considered that in an ordinary positive type resist composed of a diazonaphtoquinone compound and novolak resins, for example, the treatment with aqueous solution results in an increase in the molecular weight of the resist in the upper part (due to the reaction of the diazonaphtoquinone compound with a novolak resin or the reaction between novolak resin itself) or causes blocking of the OH group in a novolak resin with the diazonaphtoquinone compound or the reaction of the resin with the sensitive group $N_2$ of diazonaphtoquinone to form the bond $- N = N -$ with a reactive group of the resin.

Since the treatment with aqueous solution brings an increase in molecular weight of the resist in the upper part and a bridge formation, this can effectively increase the difference in the dissolving speed between exposed and unexposed portions as already discussed above even in the case of the development with an organic solvent, and result in the formation of the pattern having an improved contrast.

Such surface treatment process, moreover, will further increase the favorable effectiveness of forming a pattern when simultaneously used with such pattern contrast improving methods as the one utilizing an application of the contrast enhanced material and the one employing a whole exposure in a moisture-free atmosphere. As a matter of course, furthermore, the surface treatment process will be far more effective if used together with a simultaneous application of both contrast enhanced material and whole exposure in a moisture-free atmosphere.

The aqueous solution to be applied in the surface treatment process may contain a surface active agent, thereby a more favorable pattern formation can be obtained, due to the increase in the suppression effect of the light diffraction at the unexposed portions of the resist.

Heating after completion of the treatment with aqueous solution, moreover, also very effectively prevents a pattern from being deteriorated by the light diffraction.

The method according to the present invention permits a resist pattern to be formed in a good shape to dimensions with high accuracy and with ease through a lithographic process. And it is very suitable for the production of a miniaturized semiconductor device.

Examples of the present invention will be described below, however, the present invention is not limited thereto.

Example 1:

As shown in Fig. 3, Ordinary Positive Resist 1 (MPS-1400: Shipley), composed of a diazonaphthoquinone compound and novolak resin, was coated to a thickness of 1.2 μm on substrate such as a semiconductor 1 (Fig. 1a). Subsequently, the MF-319 (Shipley), an alkaline aqueous solution, was puddled in a state of meniscus on said Resist 2 by use of the puddle method and kept stationary for a period of 60 seconds. Figure 3 represents alkaline aqueous solution (Fig. 3b). This treatment forms Treated Layer 200 on the surface of Resist 2. And Layer 200 turns resistant to being dissolved in the alkaline developing solution, with the aforesaid action taking place. Then, the resist is exposed selectively to g-line (439 nm) Rays, ultraviolet rays, through Mask 4, using a contrast projection exposer (NA 0.42: made by Nippon Kogaku), with a exposing light quantity of 250 mJ/cm² applied. In this case, Ultraviolet Ray 5 turns in from the mask at the end as shown in Fig. 3c. Even if a portion shielded by the mask is exposed to the light in such a way, a subsequent development process will not dissolve Resist 2 at the unexposed portion because Treated Layer 200 resistant to dissolve in the alkaline developing solution has been already formed there. After that, a 60 seconds' puddle development was performed with the MF-319, an alkaline developing solution, to remove Exposed Portion 20 so that Pattern 2A was formed (Fig. 3d). Pattern 2A so obtained was a completely film-loss-free steep 0.6 μm line and space pattern with an aspect ratio of 89°.

In the present example, the aqueous solution for treatment was employed the same solution as that for the resist development. As a matter of course, however, any alkaline aqueous solution, another alkaline developing solution or any other aqueous solution (acidic or neutral) is also applicable.

The temperature for treatment with an aqueous solution is freely selectable without any particular limitations. And it has been proven that the pattern forming temperature (e.g. 15 thru 25°C) is quite problem free and applicable to the present aqueous solution.

As is clear from the above-mentioned, a developing solution applicable in an ordinary development process may be directly applicable to the aqueous solution treatment according to the present invention.

When used for mass-production of semiconductors, said treatment is very simple as a process and very valuable industrially.

In this respect, the aqueous solution treatment according to the present invention is excellent compared with a conventional organic solvent treatment in terms of throughput and process simplification. Most similar and favorable results were obtained by using other materials such as aqueous alkali solution which is an aqueous tetramethyl ammonium hydroxide solution, tetraethyl ammonium hydroxide solution, and aqueous choline solution, of alkalinormality 0.1N, 0.15N, 0.2N, 0.25, 0.3N, 0.35N, and 0.4N. Other aqueous solutions having a pH of from 1 to 7, such as acetic acid, formic acid, sulfuric acid, citric acid, and maleic acid aqueous solutions were also usable.

Example 2:

A procedure similar to that in Example 1 was employed under the conditions that the MP 2400 (Shipley Inc.), a far ultraviolet resist, was applied as the resist, a 20 seconds' immersion was made in a 2.38% tetramethyl ammonium hydroxide aqueous solution for aqueous solution treatment, that the resist exposed to a light 130 mJ/cm² by means of a KrF excimer laser stepper and that the 20% MP2401 alkaline developer (Shipley) was used to perform a 60 seconds' puddle development. As a result, a completely film-loss-free steep 0.35 μm line and space pattern with an aspect ratio of 89° was obtained.

As mentioned above, the present invention permits a neatly shaped resist pattern to be formed. And this pattern, in turn, allows carrying out a desired process of etching on a substrate such as a semiconductor device when etching an object to be etched as formed on Substrate 1. In other words, highly accurarate etching is possible, with a correct resist pattern formed according to the present invention. This is very convenient for producing a fine semiconductor device.

The method according to the present invention is further analyzed hereinunder.

For aqueous solutions, an alkaline aqueous solution has proven very effective. Nevertheless, an acidic aqueous solution or any other aqueous solution will also permit the method to be performed likewise. Applicable alkaline aqueous solutions, in particular, include tetramethyl hydroxide ammonium water solution or choline water solution. The water solution may be treated by but is not limited to such methods as immersion, puddling or spraying or a combination of these. Any other method may be used to treat the aqueous solution as long as the solution comes into contact with the resist in the upper part.

A desirable resist for the method according to the present invention is of positive or negative type. Any resist, however, may be used without limit. As far as the development is concerned, an alkaline developing solution is generally applied. Nevertheless, it may vary with the resist applied.

For exposure, ultraviolet or excimer laser rays are often applied. Nevertheless, an electron beam or X-rays is quite acceptable. With an electron beam or x-rays applied, the pattern deterioration due to dispersion of electrons can be prevented by the resist in the upper layer resistant to dissolving in the developer. Thus, a favorable pattern is obtainable.

The pattern obtainable according to the present invention, moreover, has improved heat resistance in subsequent processes thanks to the action of the resist's upper layer resistant to dissolving. As compared to a pattern produced by the conventional method, the pattern obtained according to the present invention has proven to have its heat resistance improved by 5°C to 20°C or above (showing a thermal softening point of approximately 140°C).

An aqueous solution treatment time is not particularly limitative. With the reaction taking place instantaneously, even so short a treatment time of as 10 minutes or less is often sufficient. For a treatment time beyond that, naturally, the treatment is quite free from such a phenomenon that exposed portions of the resist turn completely insoluble in the developer. In other words, the function of making the resist's upper part resistant to dissolving through the aqueous solution treatment has been found different from the phenomenon of making the resist insoluble with a conventional organic solvent. This is presumably because the aqueous solution treatment according to the present invention, even if its duration has been prolonged, scarcely proceeds after the lapse of a certain time, during which the resist in the upper part is reacting with the aqueous solution. In the conventional treatment with an organic solvent, the resist is considered to progressively turn insoluble in the developer. The present invention also allows freely setting a throughput accordingly.

The present invention, moreover, permits a desired treatment temperature to be applied to treat the aqueous solution prepared. The effectiveness of the present invention is not found to be dependent upon the temperature of an aqueous solution treatment at all.

With an aqueous solution applied, the present invention does not involve any problems in terms of safety and health while practically applying lithography. Besides, the aqueous solution is always easy to handle. This will lead to a simplification in introducing the present invention into mass-production processes. Besides, it facilitates controlling the processes and leads to an increase in device production yield.

In the present invention employing the aqueous solution treatment, furthermore, the solution is neither mixed nor reacts with the resist during the treatment. Also, such a phenomenon as a change in resist performance does not take place at all.

In addition to the resists referred to in the embodiments given above, meanwhile, the present invention permits any other resist to obtain a favorable result similar to that cited in the present embodiment, including, for example, positive resists employing a diazo naphtoquinone compound (OFPR-800, OFPR-5000 and TSMR-8900: Tokyo Applied Chemistry Co.,), HPR-204 and HPR-1182: Fuji Hunt), AZ5214 (Hoechst) and (MP2400-17 and MP1400-D2 with a Shipley dye contained therein), negative resists with an azide compound applied, (RU-1100N and RD-2000N: Hitachi Chemical), NNR747 (Nagase Sangyo), main-chain cut-off type positive resists (PMGI: Shipley) and (PMIPK and PMMA: Tokyo Applied Chemistry Co.,) and polymer type negative resists (CMS and SNR: Tosoh) and (PMGA: Tokyo Applied Chemistry Co.,). As a matter of course, applicable resists are not limited to those mentioned above. Needless to say, moreover, the present invention is applicable to the production of other than semiconductors.

Example 3:

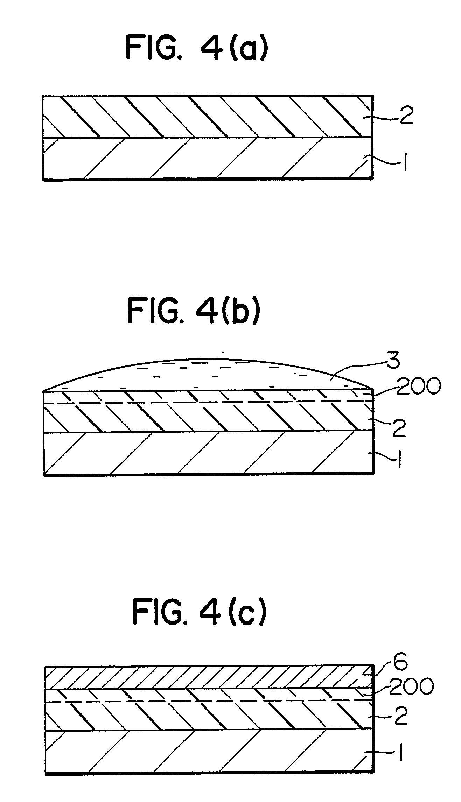

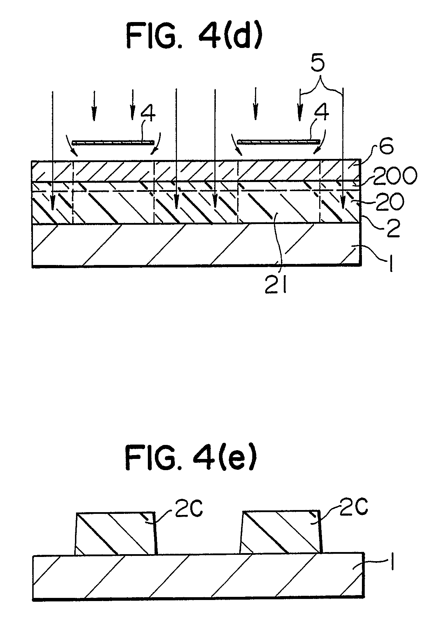

As shown in Fig. 4, Positive Resist 2 (MPS1400: Shipley) was formed to a thickness of 1.2 $\mu$m on Substrate 1 such semiconductors (Fig. 4a). Subsequently, An alkaline aqueous solution, MF-319 (Shipley), was puddled into a state of meniscus on the aforesaid Resist 2 by the puddle method and kept stationary for 60 seconds. Figure 3 represents an alkaline aqueous solution (Fig. 4b). This treatment would cause Treated Layer 200 to be formed on the surface. Subsequently, Water Soluble Material CEL Layer 6 was coated to a thickness of 0.15 $\mu$m as a layer which optically fades, relates to the present invention and has the following composition.

| | |
|---|---|
| 4,4$'$-Dimethylaminonaphthalane diazonium zinc chloride | 2.0 grams |
| polystyrene sulphonate | 8.0 grams |
| distilled water | 48.0 grams |

This water-soluble CEL Material Layer 6 has Contrast Enhanced Coefficient A = 12.0 at 436 nm (Fig. 4d)

Subsequently, Resist 2 was selectively exposed to g-line (436 nm) Ray 5 through Mask 4. Next, the exposure was made by the use of a contrast projection exposer (NA 0.42: Nippon Kogaku) at an exposing light quantity of 280 mJ/cm$^2$ (Fig. 4d). Finally, an alkaline developer (F319: Shipley) was used to carry out a puddle development and to remove the aforesaid water soluble CEL Layer 6 and Resist's Exposed Portion 20. Thus, Resist Pattern 2C was formed, comprising Unexposed Portion 21 Fig. 4e). As illustrated in the figure, obtained Pattern 2C is a completely film-loss-free steep 0.5 $\mu$m line and space pattern with an aspect ratio of 89$^\bullet$.

In the present Example, the same aqueous solution as the resist developer has been applied. Neverthless, a different alkaline aqueous solution, other alkaline developer or any other aqueous solutions (acidic or neutral aqueous solutions) are also applicable.

Any of the water solutions may have an arbitrary treatment temperature and need not be specifically limited. It has been confirmed that a pattern forming temperature (e.g. around 15 thru 25$^\bullet$) is quite safely applicable.

As is clearly stated above, the aqueous solution treatment according to the present invention permits a developer applied in an ordinary process to be applied directly. When applied for the mass-production of semiconductors, therefore, the aqueous solution treatment will considerably simplify production processes, being industrially very valuable.

In this respect, said aqueous solution treatment with the conventional organic solvent treatment in terms of throughput and process simplification.

Example 4:

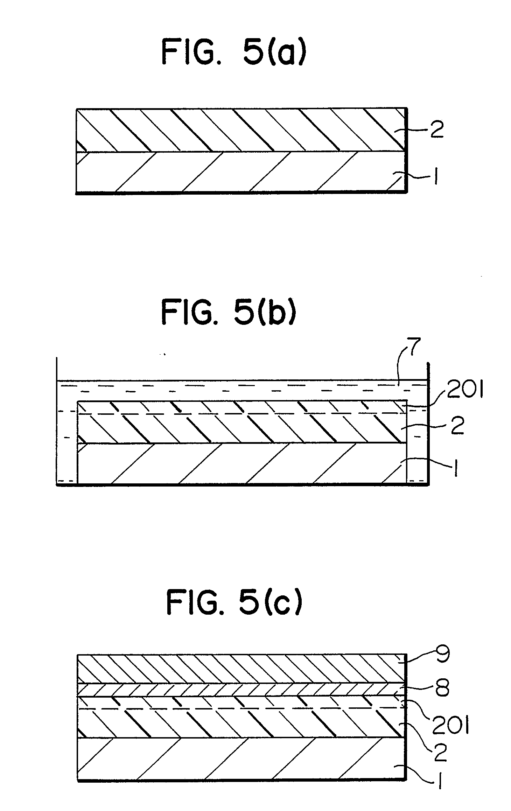

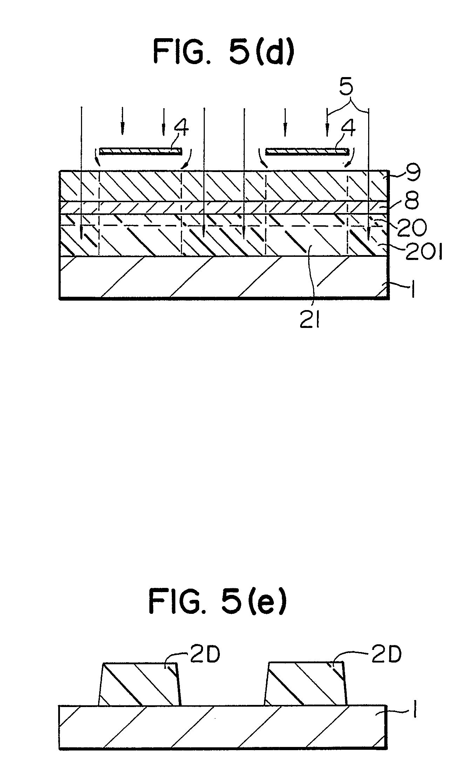

Positive Resist 2 (MPS1400: Shipley) was formed to a thickness of 1.2 μm on Substrate 1 such as semiconductors, etc (Fig. 5a). Subsequently, said substrate was immersed in Alkaline Aqueous Solution 7 (2.38% tetramethyl ammonium hydroxide aqueous solution) for 25 seconds to form Treated Layer 201 (Fig. 5b). Then, BC5 (Nagase Sangyo ) Layer 8 was formed to a thickness of 0.12 μm. After that, CEM 420 (Nagase Sangyo) Layer 9 was formed to a thickness of 0.7 μm. CEM 420 having Value A = 12.0 at 436 nm (Fig. 5c). Then, Resist 2 was selectively exposed to g-line (436 nm) Ray 5 through Mask 4. The exposure was then made by the use of a contracted projection exposer (NA 0.42: Nippon Kogaku) at an exposing light quantity of 400 mJ/cm$^2$ (Fig. 5d). Through 60 seconds' puddling with the SA15 (Nagase Sangyo), said CEM420 Layer 9 was removed and a puddle development was made for 60 seconds by the use of an alkaline developer (MF319: Shipley) to remove said BC5 Layer 8 and Resist's Exposed Portion 20. And Resist Pattern 2D was formed. (Fig. 5e) Pattern 2D so obtained was a completely film-loss-free steep 0.5 μm line-and-space pattern with an aspect ratio of 89°.

Example 5:

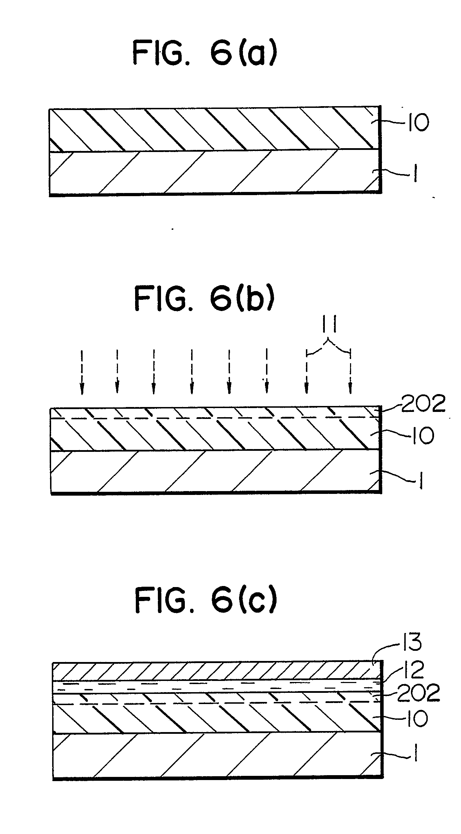

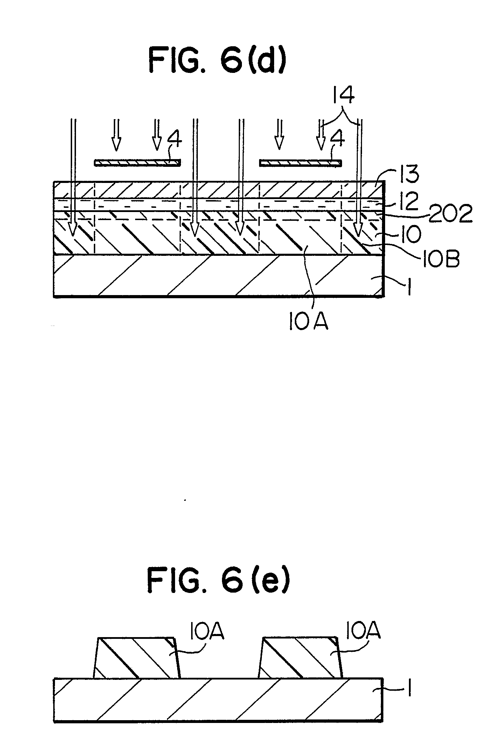

Far Ultraviolet Positive Resist 10 (MP2400: Shipley) was formed to a thickness of 1.2 μm on substrate 1, such as semiconductors, etc. (Fig. 6a). Subsequently, an alkaline aqueous solution, MP2401 (Shipley) was diluted with water at a ratio of 1 to 10. Aqueous Solution 11 so obtained was sprayed against said Resist 10 for 5 seconds to form Treated Layer 202 (Fig. 6b).

Then, Pullulan (molecular weight 3,9000: Hayashibara Biochemical Laboratory) 10% Aqueous Solution Layer 12 was formed to a thickness of 0.15 μm. And Layer 13, which had a composition as specified below and which optically fades when irradiated in relation to the present invention, was applied to a thickness of 0.25 μm as an intermediate layer.

| | |
|---|---|
| 5-diazo-Meldrum's acid | 2.3 grams |
| paracresol novolak resin (molecular weight 6000) and | 2.3 grams |
| diethyl glycol dimethyl ether | 15.4 grams |

Layer 13, which optically fades when irradiated, had Contrast Enhanced Factor A of 10.0 at 248.4 nm. In this case, Intermediate Layer 12 was mainly functioning to prevent a mixture of Layer 13 fading optically (Fig. 6c).

Subsequently, Resist 10 was selectively exposed with an KrF Excimer Laser (248.4 nm) Ray 14 through Mask 4. Next, the exposure was made by the use of a contrast projection exposer (NA 0.36) at an exposing light quantity of 280 mJ/cm$^2$ (Fig. 6d). Finally, an alkaline developer (20% MP2401) was used to carry out a 60 seconds' puddle development to remove both said Intermediate Layer 12 and Exposed Portion 10A of Resist 10. Thus, Resist Pattern 10A was formed (Fig. 6e). Pattern 10A so obtained was a completely film-loss-free 0.3 μm line-and-space pattern with an aspect ratio of 88°.

Example 6:

A procedure similar to Example 3 was repeatedly conducted under the conditions of applying the MP24000 (1.2 μm thick) as a resist, immersing in 20% Choline aqueous Solution for 15 seconds for an aqueous solution treatment, using an optically fading layer of the composition specified below (Value A = 11.0 at a thickness of 0.2 μm and at 248.4 nm), making an exposure at an exposing light quantity of 390 mJ/cm$^2$ by the use of a KrF Excimer Laser Stepper with NA = 0.36 and carrying out a 60 seconds' puddle development with 20% MP2401 alkaline aqueous solution. And a completely film-loss-free 0.375 μm line-and-space pattern was obtained with an aspect ratio of 89°.

| Composition of Optically Fading Layer Applied to the Present Invention | |
|---|---|
| polyvinyl pyrrolidone (molecular weight 260,000) | 2.0 grams |
| distilled water | 38.0 grams |

7

As referred above, the method according to the present invention allows forming a contrast-improved favorable resist pattern free from an out-of-shape. This resist pattern may be used as a mask to carry out correct etching as desired onto Substrate 1 or to an object to be etched as formed on Substrate 1. Therefore, the method according to the present invention contributes greatly to highly accurate and fine fabrications in producing semiconductor devices, etc.

For aqueous solutions, an alkaline solution has proven very effective. Neverthless, water or any other aqueous solution will also permit said method to be similarly performed. Applicable alkaline aqueous solutions, in particular, include tetramethyl ammonium hydroxide aqueous solution or chlorine aqueous solution.

The aqueous solution may be treated by, but not being limited to such methods as immersion, puddle development or spraying or a combination of them. Any other method may be used to treat the aqueous solution as long as the solution comes into contact with the resist on the surface.

A desirable resist for the method according to the present invention may be of positive or negative type. Any resist, however, may be applicable without particular limit. As far as the development is concerned, an alkaline developer is generally applied. Nevertheless, this may vary with the resist applied.

The pattern obtainable according to the present invention, moreover, has an improved heat resistance in subsequent processes due to the action of the resist's surface resistance to being dissolved. As compared with a pattern produced by an ordinary method, the pattern obtained under the present invention has proven to have its heat resistance improved by 20°C and above (showing a thermally softening point of approximately 140°C and above). The period of time for treatment with aqueous solution relating to the present invention, furthermore, is not particularly limitative because a reaction takes place instantaneously. The treatment is still often sufficient even if it is a short one such as 10 minutes or less. For a treatment time beyond that, naturally, the treatment is quite free from such a phenomenon that the exposed portions of the resist turn insoluble in the developer. In other words, aqueous solution's function of making the resist's surface resistant to dissolve in a developer has been found different from the phenomenon of making the resist insoluble with a conventional organic solvent. (In the conventional treatment with an organic solvent, the resist is considered to progressively turn insoluble in the developer.) In the water solution treatment according to the present invention, the resist turns resistant to dissolve at a very thin portion only on the surface, even if the treatment time is long. With the treatment time prolonged, the resist is assumed to have turned insoluble even into the interior in the developer.

The present invention, moreover, permits a desired treatment temperature to be applied to treat the water solution. And the effectiveness of the present invention is not found dependent upon a water solution treatment temperature at all.

With a water solution applied, the present invention does not involve any problems in terms of safety and health from the lithography. Besides, the water solution is, anyway, very easily handled. This will lead to a simplification in introducing the present invention into a practical process. Besides, it facilitates controlling processes and leads to an increase in device production yield. And it may be considered favorable in terms of mass-production.

In the present invention employing the water solution treatment, furthermore, the solution is neither mixed nor reacts with the resist during the treatment. And such a phenomenon as a change in resist performance does not take place.

For layers optically fading in relation to the present invention, any material that will increase value A relative to an exposure (e.g. 4 or more) is applicable. The optically fading layer is required to contain, for example, a diazo compound, a nitron compound or a styrylpyridine compound or a mixture of them. An applicable g-line (436) ray is available with 4.4'-dimethyl aminobenzene diazonium salt, an applicable i-line (365) ray with 4-morphorinobenziazonium salt and an applicable KrF excimer laser (248.4 nm) ray with 5-diazo Meldrum's acid.

Those enumerated above are examples of compounds practically available, all of which, are given as mere examples and to which the present invention is not limited.

In addition to the resists referred to in the embodiment given above, the present invention permits any other resist to obtain a favorable result similar to that mentioned above in the present example, including, for example, positive resists employing a diazo naphtoquinone compound (OFPR-800, OFPR-5000 and TSMR-8900: Tokyo Applied Chemistry co.,), HPR-204 and HPR-1182: Fuji Hunt), AZ5214 (Hechst) and (MP2400-17 and MP1400-D2 with a Shipley dye contained therein), negative resists with an azide compound applied, (RU-1100N and RD-2000N: Hitachi Chemical) and (NNR747: Nagase Sangyo) and main-chain cleavage type positive resist (PMGI: Shipley) and so on. As a matter of course, an applicable resist is not limited to those referred above. Needless to say, the present invention is applicable to the production of other than semiconductors.

Such an increase in difference of rates a which exposed and unexposed portions are developed as seen according to the present invention will obviously increase the contrast of a resist pattern. Thus, it has been found that a contrast improvement effect on the resist's part multiplies the incident light's contrast improvement effect arising from the CEL (optically fading layer) so that a fine, well shaped high-contrast resist pattern can be obtained. As usual, the CEL alone would not improve the pattern shape.

Example 7:

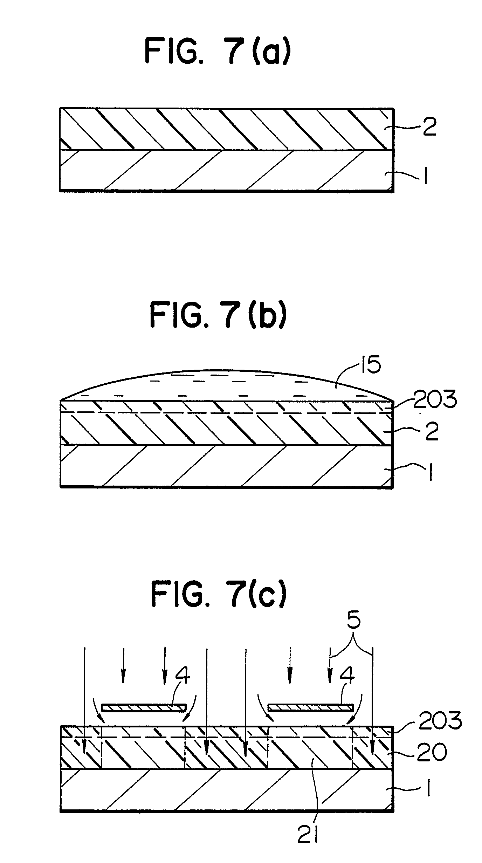

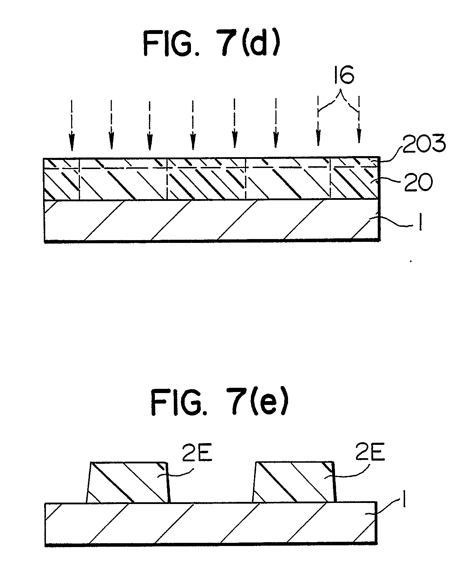

Fig. 7 is used to explain the processes in an embodiment of the pattern forming method according to the present invention. Positive Resist 2 (MPS-1400; Shipley) was formed to a thickness of 1.2 $\mu$m on Substrate 1 such as semiconductors, etc. (Fig. 7a). Subsequently, a tetramethyl ammonium hydroxide aqueous solution with an alkali normality of 0.24N was applied for 60 seconds on a puddle basis to form Treated Layer 203 (Fig. 7b). Next, the resist was exposed to g-line (436 nm) Ray 5 through Mask 4 with an exposing light quantity of 300 mJ/cm$^2$ (Fig. 5c). In this case, a contrast projection exposure unit (NA 0.42: Nippon Kogaku) was employed (Fig. 5c). Next, Far Ultraviolet Ray (10 mW/cm$^2$ at 254 nm) 16, which is derived from an Xe lamp, was radiated under a moisture-free nitrogen atmosphere (Fig. 7d). Finally, a 60 seconds' puddle development was carried out with an alkaline developer (MF-319; Shipley) to remove Exposed Portion 20 with g-line Ray 5. Thus, Pattern 2E was formed (Fig. 7e). Pattern 2F, so obtained, was a completely film-loss-free 0.6 $\mu$m line-and-space pattern with an aspect ratio of 89°. Success in obtaining such a favorable pattern free from any film loss is considered attributable to the fact that the pattern could be prevented from getting out of shape due to diffracted light, with the resist made insoluble near the surface through both aqueous solution treatment and whole exposure.

As already referred to, both aqueous solution treatment and whole exposure in a moisture-free atmosphere in the pattern forming method according to the present invention can reduce the rate of dissolving the unexposed resist near the surface of the alkaline developer and make it insoluble. These two factors' multiplication acts so that the action of making the unexposed resist alkali-insoluble will considerably reduce the film loss upon development derived from a diffracted light incident onto an unexposed portion.

Any of those mechanisms which make an unexposed portion insoluble resorts to an increase in molecular weight as a result of polymerizing a resin in resist or a resin with a photosensitive substance or to a decrease in OH group in resins.

For aqueous solutions, an alkaline solution (tetra methyl ammonium hydroxide or choline aqueous solution) could be generally specified, to which the present invention, however, is not limited. An appropriate aqueous solution treatment method, moreover, is selectable from immersion, puddle, spray or a combination thereof.

For whole exposure, either ultraviolet or far ultraviolet rays are applicable. To prevent a photosensitive substance in the resist from dissolving in the alkaline developer, with carboxylic acid produced through oxidation of the medium, however, it is preferable to carry out the whole exposure in vacuum or in a nitrogen atmosphere.

Example 8:

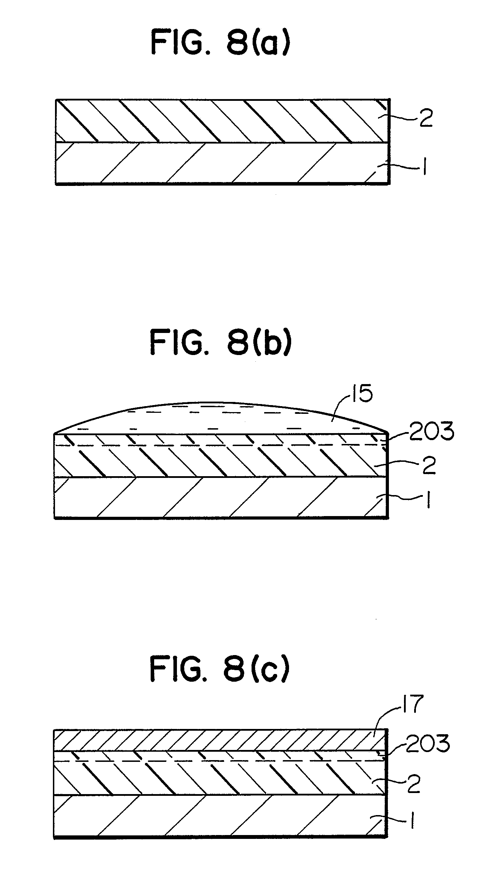

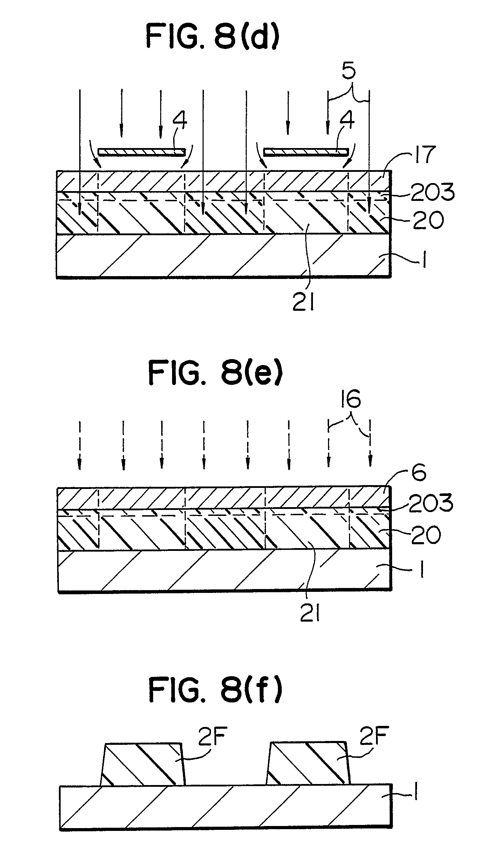

Referring to Fig. 8, an explanation is given concerning the processes in an embodiment of the pattern forming method according to the present invention. Positive Resist 2 (MPS-1400: Shipley) was formed to a thickness of 1.2 $\mu$m on Substrate 1 such as semiconductors, etc. (Fig. 8a). Subsequently, Tetramethyl Ammonium Hydroxide Aqueous Solution 15 with an alkaline normality of 0.24N was applied for 60 seconds on a puddle basis to form Treated Layer 203 (Fig. 8b). Next, an optically fading material comprising 4-dimethylamino naphthalene diazonium chloride zinc salt, polystyrene sulphonate and water at a ratio of 1 to 7 to 15 in that order was applied. As a result, 0.15 $\mu$m Optically Fading Layer 17 was obtained (Fig. 8c).

Then, the resist was exposed to g-line Ray 5 through Mask 4 employing a contracted projection exposer (NA 0.42; Nippon Kogaku) at an exposing light quantity of 330 mJ/cm$^2$ (Fig. 8d). Subsequently, Far Ultraviolet Ray 16 (10 mW/cm$^2$) at 254 nm, emitted from an Xe lamp, was radiated for 5 seconds in a nitrogen atmosphere (Fig. 8e). Finally, a 60-seconds' puddle development was made with an alkaline developer (MF-319; Shipley) to remove both Optically Fading Layer 17 and Resist 20 at a portion exposed to Ray 5. As a result, Resist Pattern 2F was obtained (Fig. 8f). Pattern 2F, so obtained, was a completely film-loss-free 0.6 $\mu$m line-and-space pattern with an aspect ratio of 89°.

In this process, meanwhile, an identically favorable result has been obtained even when the optically fading layer has been removed (flushed away with water) prior to the whole exposure. Such a favorable pattern as the present embodiment has arisen, as already referred to, from a combination of both said insoluble layer formed on the surface and rays with contrast improved. It may be considered as a multiplied result of improving both resist and incident rays.

As referred above, both aqueous solution treatment and whole exposure in a moisture-free atmosphere can reduce the rate of dissolving alkali around an exposed portion of the resist and make it insoluble. Applying an optically fading layer, moreover, will reduce the incidence of a diffracted light with a low intensity onto an exposed portion. These three interacting factors will decrease the rays diffractedly incident onto an unexposed portion. And the ray which has been incident will not cause any film loss at all, with the exposed portion made insoluble upon development due to an action of the former two.

Either of the above-mentioned two mechanisms which make an exposed portion unsoluble increase in molecular weight as a result of either polymerizing the resin in a resist or a resin with a photosensitive substance; or, a decrease in OH group in the resins.

An optically fading layer, which absorbs the light of low intensity, contains a diazo compound, a nitron compound, a styryl pyridine compound, etc. Only the rays of high intensity fade the layers and become the incident onto the resist. In other words, the scarcely diffracted rays whose contrast has been improved can only become the incidents.

For aqueous solutions, an alkaline solution (tetra methyl ammonium hydroxide or choline aqueous solution) could be generally specified, however, the present invention, is not limited thereto.

An appropriate aqueous solution treatment method, moreover, can be selectable from immersion, puddle, spray or a combination thereof.

For whole exposure, either ultraviolet or far ultraviolet rays are applicable. To prevent a photosensitive substance in the resist from dissolving in the alkaline developer, with the formation of carboxylic group through oxidation of the substance, it is preferable to carry out the whole exposure in vacuum or in a nitrogen atmosphere.

Example 9

Positive Resist 2 (MPS-1400: Shipley) was formed to a thickness of 1.2 μm on Substrate 1 such as semiconductors, etc. Subsequently, the tetramethyl ammonium hydroxide aqueous solution with an alkali normality of 0.24N, which contains 500 ppm of the $CF_3(CF_3)_7SO_2N(C_2H_5)$ $(CH_2CH_2O)_{14}H$ surface active agent, was applied for 60 seconds on a puddle basis. Next, the resist was exposed to the g-line ray through a mask. The exposure unit employed was a contrast projection exposer (NA 0.42; Nippon Kogaku) at an exposing light quantity of 250 mJ/cm$^2$. Finally, a 60-seconds' puddle development was made with an alkaline developer (MF-319; Shipley) to remove the exposed portion from the resist. Thus, a resist pattern was formed. The pattern so obtained was a completely film-loss-free 0.6 μm line-and-space pattern with an aspect ratio of 89°.

Such a favorable pattern free from any film loss is attributable to the blockings of diffracted light on the surface by the layer which is made insoluble. Thus, the present invention has succeeded in remarkable decrease of those film loses and miss-shapes, which have taken place due to the optical diffraction of a pattern in the conventional method.

Thus, an aqueous solution containing a surface active agent applied to the pattern forming method according to the present invention is to reduce the rate of dissolving in an alkaline solution at the vicinity of the surface of a resist portion unexposed and to make it insoluble. Consequently, the present invention is to remarkably reduce the film loss upon development derived from the diffracted light incident onto an unexposed portion.

Thus, the mechanisms which make an unexposed portion insoluble increase molecular weight as a result of polymerizing a resin in a resist or a resin with a photosensitive substance or to a decrease in OH groups in resins. For example, such a reaction takes place in an alkaline aqueous solution. This reaction, however, will be doubled in both speed and extent if a surface active agent is added. The pattern forming method according to the present invention has been found very advantageous in terms of throughput and yield in their industrial sense.

Surface active agents generally available contain fluorine atom have an ether linkage, a COOH or SO$_3$H group.

Typical surface active agents may be taken up, for example, as follows:
The surface active agents are for example,

$CF_3(CF_2)$, $(CH_2CH_2O)_{10}H$, $CF_3(CF_2)_7SO_2N(C_2H_3)(CH_2(CH_2O)_{14}H$, $CF_3(CF_2)_7(CH_2)_3CON(CH_3)(CH_2CH_2O)_{10}H$, $C_7F_{15}COONH_4$, $C_7F_{15}COOH$, $C_8F_7SO_3H$, $C_7F_{15}COON(CH_3)_4$.

For aqueous solutions associated with the present invention, tetra methyl ammonium hydroxide or choline aqueous solution could be generally taken up as an alkaline aqueous solution. The present invention, however, is not limited thereto.

An appropriate aqueous solution treatment method, moreover, is selectable from immersion, puddle, spray or a combination thereof.

Example 10:

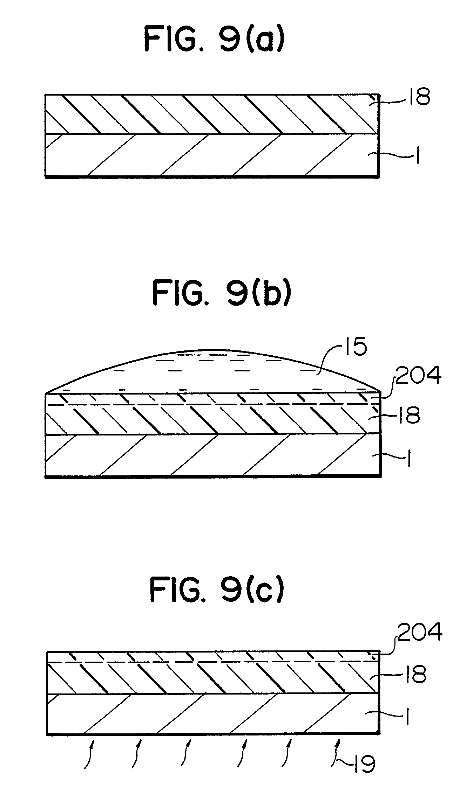

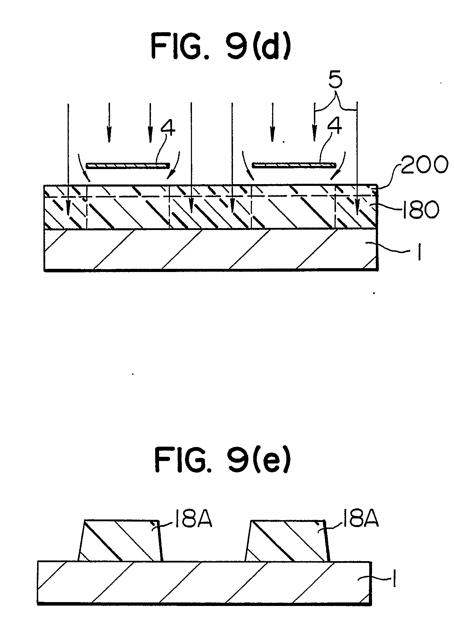

The pattern forming method according to the present invention is described by referring to Fig. 9.

The TSMR8900, Photosensitive Resin 18, was formed to 1.2 μm on Substrate 1 such as semiconductors, etc. (Fig. 9a). And it was treated with Tetramethyl Ammonium Hydroxide (0.24N) 15 for 60 seconds and Treated Layer 204 was formed (Fig. 9b). Said Substrate was heated at 100°C for 90 seconds 19 (Fig. 9c). Desired Pattern Exposure 18 through Maks 4 was made by the use of a g-line stepper (NA 0.42) (Fig. 9d). The NMD-3 was used to carry out a 60 seconds development to remove Exposed Portion 180. Thus, Pattern 18A was formed (Fig. 9e). Resist Pattern 18A, so obtained, was a film-loss-free 0.5 μm line-and-space pattern with an aspect ratio of 88°.

An identically favorable result can be available even without heating after applying said photosensitive resin onto said substrate upon formation.

To overcome such problems in the prior art, the present invention provides a pattern forming method wherein a pattern is formed after completion of both aqueous solution treatment and heating.

The pattern forming method according to the present invention has its heating process promote the insolubility of a photosensitive resin in an alkaline developer through the aqueous solution treatment. This action makes the photosensitive resin at an unexposed portion more resistant to dissolve in the alkaline developer. As a result, this heating was done because it was considered to enhance the resist treatment, the pattern is prevented from deteriorating its contrast due to a diffracted rays. Thus, the pattern shape is improved. The photosensitive resin at an exposed portion, on the other hand, has its alkaline solubility increased due to an optical decomposition of the photosensitive substance (with indene carboxylic acid, for example, generated). Consequently, the dissolving rate of the exposed portion relative to the developer remains unchanged.

Therefore, the method according to the present invention permits a high aspect ratio pattern to be formed as a result of increasing the difference in dissolving rates between exposed and unexposed portions.

According to the present invention, meanwhile, the insolubility of a photosensitive resin owing to an aqueous solution treatment may be considered to have thermally penetrated and dispersed up to the interior of the photosensitive resin.

Any aqueous solutions are applicable in relation to the present invention. Such an organic amine aqueous solution as tetramethyl ammonium hydroxide and tetraethyl ammonium hydroxide or such alkaline aqueous solutions as choline aqueous solution and diethanolamine or any other neutral or acidic aqueous solutions, for example, aqueous solution such as acetic acid, formic acid, sulfuric acid, citric acid, and maleic acid or an aqueous solution of pH 1 to 7 could be used. An alkaline aqueous solution, moreover, may contain an additive, such as surface active agent, etc.

For heating, the temperature of 130° is desirable so as to prevent the photosensitive resin from deteriorating its sensitivity. The heating temperature, however, is not limited to the above-mentioned temperature range.

Heating may be carried out at any time after completion of the aqueous solution treatment, either before or after the exposure to the rays or both before and after. The effect of the heat treatment will then perform satisfactorily.

Such heating, meanwhile, is applicable combined with the aforesaid optically fading compound layer or with far ultraviolet radiation in addition to the water solution treatment. In this manner, the heat treatment can attain a more effective improvement of pattern shapes, etc.

**Claims**

1. A pattern forming method which comprises forming a resist on a substrate, treating said resist with an aqueous solution so as to form a surface-treated layer which is a developing-resistant one, removing selectively said resist by exposing it to a ray and subjecting the exposed resist to a development treatment, and forming a pattern of the resist.

2. A pattern forming method which comprises forming a resist on a substrate, treating said resist with an aqueous solution so as to form on said resist a surface-treated layer which is a developing-resistant one, forming a layer capable of optically fading with an irradiation, exposing selectively said resist, removing said layer capable of fading with the irradiation subjecting said resist to a development treatment thereby removing selectively said resist and forming a pattern of the resist.

3. A pattern forming method which comprises forming a resist on a substrate, treating said resist with an aqueous solution so as to form on said resist a surface-treated layer which is a developing-resistant one, exposing selectively said resist, then subjecting resist selectively exposed to whole irradiation with a ray under moisture-free atmosphere, subjecting thus exposed resist to a development treatment so as to remove selectively the resist to form a pattern of the resist.

4. A pattern forming method according to Claim 1 or 2 wherein said resist is further subjected to whole irradiation in a moisture-free atmosphere after selective exposure of said resist to a ray; and removing selectively wholly irradiated resist to form pattern of said resist.

5. A pattern forming method according to any of Claims 1, 2, 3 and 4 wherein said aqueous solution is an acidic aqueous solution or an alkaline aqueous solution.

6. A pattern forming method according to Claim 5 wherein said alkaline aqueous solution is a tetramethyl ammonium hydroxide aqueous solution or choline aqueous solution.

7. A pattern forming method according to any of Claims 1, 2, 3 and 4 wherein said aqueous solution treatment is conducted by immersion, puddle or spray or a combination thereof.

8. A pattern forming method according to Claim 2 or 4 wherein said layer capable of fading with an irradiation contains a diazo compound or nitron compound or styrylpyridine compound.

9. A pattern forming method according to any of Claim 3 or 4 wherein said moisture-free condition are vacuum or a nitrogen atmosphere.

10. A pattern forming method according to either Claim 3 or 4 wherein said whole irradiation is made with ultraviolet or far ultraviolet rays.

11. A pattern forming method according to any of Claim 1, 2, 3 and 4 wherein said aqueous solution contains a surface active agent.

12. A pattern forming method according to Claim 11 where said surface active agent contains fluorine atom or either ether linkage or -COOH group or $-SO_3$ group or at least two of the above-mentioned atom, linkage and groups.

13. A pattern forming method according to any of Claims 1, 2, 3 and 4 wherein a heating treatment is performed after completion of said aqueous solution treatment.

14. A pattern forming method according to Claim 13 wherein said heating treatment is performed prior to said exposure.

15. A pattern forming method according to Claim 13 wherein said heating treatment is performed after completion of said exposure.

16. A pattern forming method according to Claim 13 wherein said heating treatment is performed both before and after said exposure.

# FIG. I (a)

# FIG. I (b)

# FIG. I (c)

# FIG. 2(a)

# FIG. 2(b)

# FIG. 2(c)

# FIG. 2(d)

# FIG. 3 (a)

2

1

# FIG. 3 (b)

3

2

1

# FIG. 3 (c)

5

4

4

200

20

2

1

21

# FIG. 3 (d)

2A

2A

1

# FIG. 4(a)

# FIG. 4(b)

# FIG. 4(c)

## FIG. 4(d)

## FIG. 4(e)

# FIG. 5(a)

# FIG. 5(b)

# FIG. 5(c)

## FIG. 5(d)

## FIG. 5(e)

# FIG. 6(a)

10
1

# FIG. 6(b)

11

202
10
1

# FIG. 6(c)

13
12
202
10
1

# FIG. 6(d)

14

4

13
12 202
10
10B
1

10A

# FIG. 6(e)

10A    10A

1

# FIG. 7 (a)

# FIG. 7 (b)

# FIG. 7(c)

# FIG. 7(d)

# FIG. 7(e)

# FIG. 8(a)

# FIG. 8(b)

# FIG. 8(c)

## FIG. 8(d)

5

4

4

17

203

20

1

21

## FIG. 8(e)

16

6

203

20

1

21

## FIG. 8(f)

2F

2F

1

# FIG. 9(a)

18

I

# FIG. 9(b)

15

204

18

I

# FIG. 9(c)

204

18

I

19

# FIG. 9(d)

# FIG. 9(e)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol. 26, no. 5, October 1983, page 2652, New York, US; S.J. GILLESPIE: "Directional etch mask in single layer resist" * Whole article * | 1-16 | G 03 F 7/26 |
| X | IBM TECHNICAL DISCLOSURE BULLETIN, vol. 21, no. 6, November 1978, pages 2306-2308, New York, US; J. HAVAS et al.: "Control of developed image profile in AZ-type photo and electron resist" * Whole article * | 1-16 | |
| X | PATENT ABSTRACTS OF JAPAN, vol. 7, no. 138 (P-204)[1283], 16th June 1983; & JP-A-58 52 644 (TOKYO SHIBAURA DENKI K.K.) 28-03-1983 * Abstract * | 1-16 | |
| X | PATENT ABSTRACTS OF JAPAN, vol. 6, no. 237 (P-157)[1115], 25th November 1982; & JP-A-57 136 646 (DAINIHON SCREEN SIEZOU K.K.) 23-08-1982 * Abstract * | 1-16 | TECHNICAL FIELDS SEARCHED (Int. Cl.4) G 03 F 7/00 |
| A | EP-A-0 100 938 (TORAY INDUSTRIES) * Whole document * | 1 | |
| A | EP-A-0 195 322 (HOECHST) * Whole document * | 1 | |

The present search report has been drawn up for all claims

| Place of search | Date of completion of the search | Examiner |
|---|---|---|
| THE HAGUE | 26-01-1989 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P0401)